# EUROPÄISCHE PATENTSCHRIFT

(11) **EP 3 531 804 B1**
(45) Veröffentlichungstag und Bekanntmachung des Hinweises auf die Patenterteilung: **07.04.2021**
(21) Anmeldenummer: 19156817.9
(22) Anmeldetag: 13.02.2019
(51) Int. Cl.: H05H 1/24, H01J 37/32

(54) **NIEDERDRUCKPLASMAKAMMER, NIEDERDRUCKPLASMAANLAGE UND VERFAHREN ZUR HERSTELLUNG EINER NIEDERDRUCKPLASMAKAMMER**
LOW PRESSURE PLASMA CHAMBER, LOW PRESSURE PLASMA SYSTEM AND METHOD FOR PRODUCING A LOW PRESSURE PLASMA CHAMBER
CHAMBRE À PLASMA BASSE PRESSION, INSTALLATION À PLASMA BASSE PRESSION ET PROCÉDÉ DE FABRICATION D'UNE CHAMBRE À PLASMA BASSE PRESSION

(30) Priorität: 21.02.2018 DE 102018103949
(43) Veröffentlichungstag der Anmeldung: 28.08.2019
(73) Patentinhaber: Diener, Christof-Herbert, 72202 Nagold (DE)
(72) Erfinder: Diener, Christof-Herbert, 72202 Nagold (DE)
(74) Vertreter: Kohler Schmid Möbus Patentanwälte

(56) Entgegenhaltungen:
- EP-A2- 0 715 342
- WO-A1-2006/009281
- CH-A- 228 540
- CN-U- 204 145 866
- DE-A1- 2 224 019
- DE-A1- 2 840 844
- JP-A- 2004 281 229

## Beschreibung

Es ist bekannt, Niederdruckplasmaanlagen einzusetzen, um Bauteile (Proben/Werkstücke) einer Vakuumbehandlung und/oder Plasmabehandlung zu unterziehen. Solche Niederdruckplasmaanlagen weisen eine Niederdruckplasmakammer auf. Eine chemisch und physikalisch besonders inerte Niederdruckplasmakammer kann dabei erreicht werden, wenn ein Niederdruckplasmakammerkörper aus Glas ausgebildet ist. Bei Niederdruckplasmakammerkörpern aus Metall können geringe Mengen Metall abgesputtert werden. Dies bedeutet, dass im Plasma durch den Beschuss mit energiereichen Ionen geringe Mengen Metall herausgelöst werden und in die Gasphase übergehen. Dies kann die Verschmutzung der zu behandelnden Bauteile in der Niederdruckplasmakammer zur Folge haben.

Die bekannten Niederdruckplasmakammerkörper aus Glas werden in Handarbeit hergestellt. Dabei werden vorgefertigte, im Querschnitt kreisförmige, Glasröhren eingesetzt. Der Querschnitt der bekannten Niederdruckplasmakammerkörper ist daher kreisförmig.

Durch den im Querschnitt runden Niederdruckplasmakammerkörper wird jedoch das Plasma inhomogen. Aus der inhomogenen Feldlinienverteilung bei einer in Querschnitt runden Niederdruckplasmakammer resultiert ein schlechtes und inhomogenes Plasma. Die Korrektur eines solchen inhomogenen Plasmas ist nur auf aufwendige Art und Weise durch eine Anpassung der Elektroden und/oder Ansteuerung der Elektroden möglich.

Aus der US 4,804,431 A ist eine Plasmaanlage bekannt geworden, die auf der Verwendung eines konventionellen Mikrowellengeräts beruht. Figur 10 der US 4,804,431 A offenbart eine mehreckige "inverted bell jar" 402, die auf Bodenplatte 404 aus Aluminium aufgesetzt ist. Die US 4,804,431 A lehrt jedoch in Spalte 2, Zeilen 38-43, ebenfalls, vorzugsweise röhrenförmige Niederdruckplasmakammerkörper einzusetzen.

Ferner offenbart JP 2004-281229 A eine Niederdruckplasmakammer umfassend einen viereckigen Niederdruckplasmakammerkörper, wobei ein Plasma durch eine Elektrode in diesen Niederdruckplasmakammerkörper eingeleitet wird.

Weiter offenbart CH 228540 ein Verfahren zur Herstellung einer Niederdruckplasmakammer, wobei ein Niederdruckplasmakammerkörper im Pressverfahren oder Blas-Blas-Verfahren hergestellt wird.

Die Aufgabe der vorliegenden Erfindung ist es demgegenüber, auf konstruktiv einfache Art und Weise eine Niederdruckplasmakammer bereitzustellen, die ein homogenes Plasma im Inneren der Niederdruckplasmakammer ermöglicht. Die Aufgabe der vorliegenden Erfindung ist es weiterhin, eine Niederdruckplasmaanlage mit einer solchen Niederdruckplasmakammer sowie ein Verfahren zur Herstellung einer Niederdruckplasmakammer bereitzustellen.

Die Aufgabe wird erfindungsgemäß durch eine Niederdruckplasmakammer gemäß Patentanspruch 1, eine Niederdruckplasmaanlage gemäß Patentanspruch 8 und ein Verfahren zur Herstellung einer Niederdruckplasmakammer gemäß Patentanspruch 9 gelöst. Die abhängigen Patentansprüche geben bevorzugte Weiterbildungen wieder.

Die erfindungsgemäße Aufgabe wird somit gelöst durch eine Niederdruckplasmakammer zur Plasmabehandlung bzw. Vakuumbehandlung eines Bauteils in ihrem Inneren. Die Niederdruckplasmakammer weist einen Niederdruckplasmakammerkörper auf. Der Niederdruckplasmakammerkörper ist aus Glas ausgebildet. Der Niederdruckplasmakammerkörper weist einen mehreckigen Querschnitt auf.

Der Niederdruckplasmakammerkörper kann alternativ aus Porzellan ausgebildet sein. Das Porzellan kann Kaolin, Feldspat und Quarz aufweisen.

Die Ausbildung eines im Querschnitt mehreckigen Niederdruckplasmakammerkörpers erlaubt die Anordnung von geraden und/oder ebenen, nicht gebogenen, Elektroden am Niederdruckplasmakammerkörper zum Erzeugen eines Plasmas. Eine aufwendige Berechnung und Konstruktion der Elektroden bzw. eine aufwendige Ansteuerung der Elektroden ist unnötig. Der mehreckige Niederdruckplasmakammerkörper ermöglicht somit auf konstruktiv einfache Art und Weise das Erzeugen eines homogenen Plasmas im Inneren des Niederdruckplasmakammerkörpers bzw. der Niederdruckplasmakammer.

Eine besonders homogene Feldlinienverteilung wird erzielt, da der Querschnitt des Niederdruckplasmakammerkörpers viereckig, insbesondere rechteckig, besonders bevorzugt quadratisch, ausgebildet ist. Unter einem viereckigen Querschnitt wird dabei verstanden, dass der Niederdruckplasmakammerkörper vier Außenwände aufweist, die das Innenvolumen des Niederdruckplasmakammerkörpers radial begrenzen, wobei die vier Außenwände über abgerundete oder nicht abgerundete Ecken ineinander übergehen.

Die Niederdruckplasmakammer kann zur Erzeugung des Plasmas Elektroden und/oder zumindest eine Spule aufweisen. Alternativ oder zusätzlich dazu kann die Niederdruckplasmakammer einen Mikrowellengenerator aufweisen.

Weiter bevorzugt erstreckt sich der Niederdruckplasmakammerkörper länglich in Richtung seiner Längsachse. Der Niederdruckplasmakammerkörper ist dabei zum Erreichen einer besonders homogenen Feldlinienverteilung vorzugsweise in Richtung der Längsachse betrachtet zu mehr 40%, insbesondere zu mehr als 60%, besonders bevorzugt zu mehr als 80%, axialsymmetrisch zu seiner Längsachse ausgebildet.

In einer weiteren bevorzugten Ausgestaltung der Erfindung ist der Querschnitt des Niederdruckplasmakammerkörpers entlang seiner Längsachse zu mehr als 40%, insbesondere zu mehr als 60%, besonders bevorzugt zu mehr als 80%, gleich ausgebildet. Mit anderen Worten erstreckt sich der Niederdruckplasmakammerkörper in diesem Fall überwiegend gleichmäßig entlang seiner Längsachse.

Erfindungsgemäß weist die Niederdruckplasmakammer eine werkzeugfrei J Z reversibel öffen- und schließbare Tür auf.

Die Tür kann zumindest einen Medienanschluss, insbesondere in Form eines Gasanschlusses, aufweisen.

Erfindungsgemäß weist der Niederdruckplasmakammerkörper eine Öffnung mit einem Kragen auf, an dem die Tür befestigt ist. Der Kragen bzw. Rand des Niederdruckplasmakammerkörpers ist dabei bevorzugt mit zumindest einer Bohrung, insbesondere mit mehreren Bohrungen, zur Befestigung der Tür versehen. Hierdurch kann die Tür besonders einfach montiert und demontiert werden.

Erfindungsgemäß weist der Niederdruckplasmakammerkörper eine Rückwand aus Glas oder Porzellan auf. Die Rückwand kann teilweise oder vollständig geschlossen sein.

Weiter bevorzugt ist die Rückwand des Niederdruckplasmakammerkörpers teilweise, insbesondere kreisförmig, geöffnet, wobei ein plattenförmiger, insbesondere kreisscheibenförmiger, Rückwandverschluss der Niederdruckplasmakammer in eine Rückwandöffnung im Niederdruckplasmakammerkörper eingesetzt ist. Der Rückwandverschluss kann zumindest einen Medienanschluss, insbesondere in Form eines Anschlusses für eine Vakuumpumpe, aufweisen. In besonders bevorzugter Ausgestaltung der Niederdruckplasmakammer weist sowohl die Tür als auch die der Tür entgegengesetzte Rückwand jeweils zumindest einen Medienanschluss auf. Prozessgase können auf diese Art und Weise einenends der Niederdruckplasmakammer eingeströmt und anderenends abgesaugt werden. Dies erlaubt eine besonders homogene Gasverteilung, durch die das Plasma weiter homogenisiert wird. Sind demgegenüber Medienanschlüsse nur an einer Seite der Niederdruckplasmakammer vorgesehen, so strömen Prozessgase nur an dieser Seite ein und werden gleich wieder abgesaugt, was zu einem imhomogeneren Plasma führt.

Erfindungsgemäß ist der Niederdruckplasmakammerkörper einteilig, d.h. einstückig, ausgebildet.

Der Niederdruckplasmakammerkörper kann aus Halogenidglas, Chalkogenidglas, Phosphatglas, Alumosilikatglas, Bleisilikatglas, Alkali-Silikatglas, Borosilikatglas, oder Alkaliboratglas ausgebildet sein. Der Niederdruckplasmakammerkörper ist bevorzugt aus Kalk-Natron-Glas, Borosilikatglas oder Quarzglas ausgebildet. Kalk-Natron-Glas ist ein Massenglas, das zur Fertigung von Behälterglas und Flachglas verwendet wird. Borosilikatglas ist ein sehr chemikalienbeständiges und temperaturbeständiges Glas, das vor allem für Glasgeräte im Labor, der chemischen Verfahrenstechnik und im Haushalt eingesetzt wird. Es hat den Vorteil, dass es sich bei Hochfrequenzen nicht dielektrisch erwärmt. Quarzglas ist ein Glas, das im Gegensatz zu den gebräuchlichen Gläsern keine Beimengungen von Soda oder Kalziumoxid enthält, also aus reinem Siliziumdioxid besteht.

Die erfindungsgemäße Aufgabe wird weiterhin gelöst durch eine Niederdruckplasmaanlage mit einer hier beschriebenen Niederdruckplasmakammer. Die Niederdruckplasmaanlage weist eine mit der Niederdruckplasmakammer verbundene Vakuumpumpe, eine mit der Niederdruckplasmakammer verbundene Gasversorgung und/oder eine mit der Niederdruckplasmakammer verbundene Plasmaspannungsversorgung auf.

Die erfindungsgemäße Aufgabe wird weiterhin gelöst durch ein Verfahren zur Herstellung einer hier beschriebenen Niederdruckplasmakammer, wobei der

Niederdruckplasmakammerkörper im Pressverfahren hergestellt wird

In weiteren beispielhaften Verfahren, die außerhalb des Schutzbereiches der vorliegenden Erfindung liegen, wird der Niederdruckplasmakammerkörper im Blas-Blas Verfahren herstellt.

Im Pressverfahren kann ein mehrteiliges Werkzeug eingesetzt werden, wobei das Werkzeug eine Form und einen Stempel aufweist. Vorzugsweise weist im Pressverfahren das mehrteilige Werkzeug weiterhin einen Deckring auf.

Die Werkzeugteile können im erfindungsgemäßen Verfahren unterschiedlich temperiert werden. Besonders bevorzugt werden die Form und der Stempel gekühlt. Der Deckring kann gekühlt oder beheizt werden.

In Blas-Blas-Verfahren, die außerhalb des Schutzbereichs der vorliegenden Erfindung liegen, werden vorzugsweise die Verfahrensschritte
a) Füllen einer Vorform; b) Festblasen; c) Vorblasen; und d) Fertigblasen durchgeführt.

Der im Rahmen der vorliegenden Erfindung beschriebene Niederdruckplasmakammerkörper ist vorzugsweise durch ein hier beschriebenes Verfahren, d.h. im Pressverfahren oder Blas-Blas-Verfahren, bzw. deren Ausbildungen hergestellt.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung Der Schutzbereich der vorliegenden Erfindung wird durch die Patentansprüche bestimmt.

Es zeigen:
- Figur 1: eine schematische Niederdruckplasmaanlage gemäß dem Stand der Technik;
- Figur 2a: eine erfindungsgemäße Niederdruckplasmaanlage;
- Figur 2b: eine perspektivische Ansicht einer Tür einer erfindungsgemäßen Niederdruckplasmakammer;
- Figur 2c: einen erfindungsgemäßen Niederdruckplasmakammerkörper;
- Figur 2d: eine Draufsicht auf einen plattenförmigen Rückwandverschluss zum Einsatz in dem Niederdruckplasmakammerkörper gemäß Figur 2c;
- Figur 3: eine schematische Darstellung eines erfindungsgemäßen Verfahrens zur Herstellung des Niederdruckplasmakammerkörpers gemäß Figur 2c.

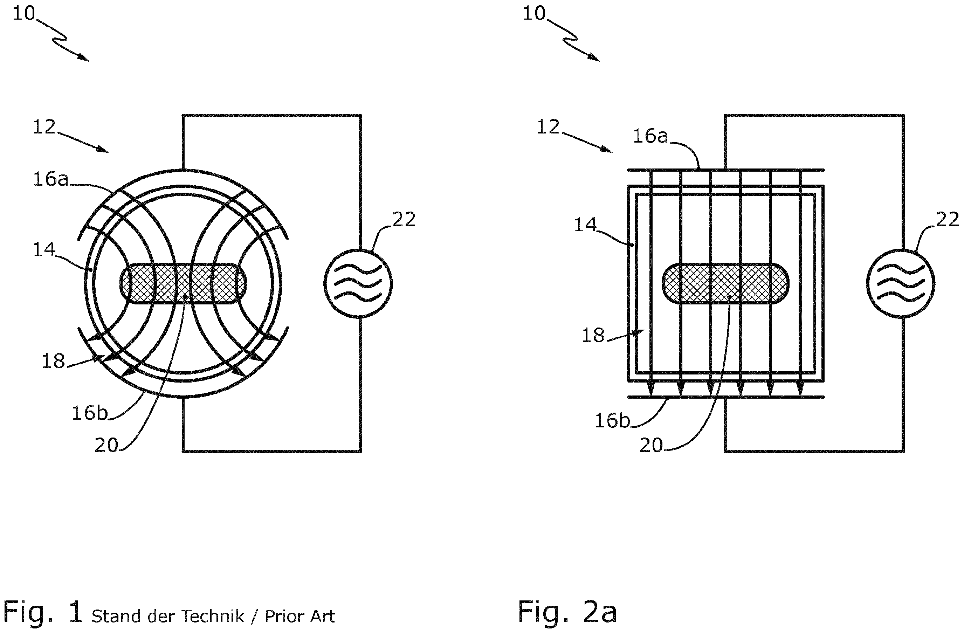

**Figur 1a** zeigt eine Niederdruckplasmaanlage **10** gemäß dem Stand der Technik. Mit Stand der Technik ist dabei gemeint, dass Niederdruckplasmaanlagen in der Art gemäß Figur 1a dem Anmelder bekannt sind. Es handelt sich jedoch nicht zwangsläufig um veröffentlichten Stand der Technik.

Die Niederdruckplasmaanlage 10 weist eine Niederdruckplasmakammer **12** mit einem Niederdruckplasmakammerkörper **14** aus Glas auf. Der Niederdruckplasmakammerkörper 14 weist einen runden, hier kreisförmigen Querschnitt auf. Elektroden **16a, 16b** umgeben bogenförmig den Niederdruckplasmakammerkörper 14, sodass Feldlinien **18** bogenförmig in der Niederdruckplasmakammer 12 vorliegen. In die Niederdruckplasmakammer 12 ist ein Bauteil **20** zur Plasmabehandlung eingebracht. Das Plasma wird durch eine Plasmaspannungsversorgung **22** erzeugt.

Aufgrund der gebogenen Feldlinien 18 ist das im Niederdruckplasmakammerkörper 14 gezündete Plasma inhomogen. Aufgabe der Erfindung ist es demgegenüber, ein homogenes Plasma bereitzustellen, wobei der Niederdruckplasmakammerkörper 14 chemisch und physikalisch weitestgehend inert und die Elektroden konstruktiv einfach ausgebildet sein sollen.

**Figur 2a** zeigt schematisch eine erfindungsgemäße Niederdruckplasmaanlage 10. Die Niederdruckplasmaanlage 10 weist eine Niederdruckplasmakammer 12 mit einem Niederdruckplasmakammerkörper 14 in Form eines im Querschnitt rechteckigen Glaskörpers auf. Der Niederdruckplasmakammerkörper 14 wird von Elektroden 16a, 16b flankiert. Die Elektroden 16a, 16b sind vorzugsweise einander gegenüberliegend am Niederdruckplasmakammerkörper 14 angeordnet. Die Elektroden 16a, 16b sind vorzugsweise eben ausgebildet. Hierdurch werden gerade Feldlinien 18 erzeugt. Ein in die Niederdruckplasmakammer 12 eingebrachtes Bauteil 20 ist einem homogenen Plasma ausgesetzt. Das Plasma wird vorzugsweise durch eine Plasmaspannungsversorgung 22 erzeugt.

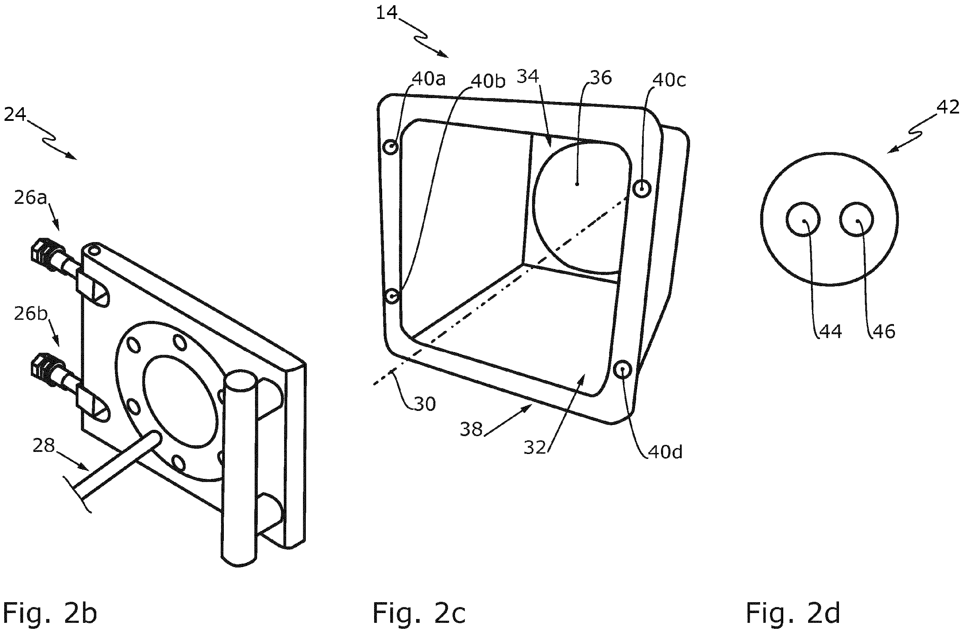

Die Niederdruckplasmakammer 12 gemäß Figur 2a ist in den Figuren 2b bis 2d - ohne die Elektroden 16a, 16b bzw. ohne die Plasmaspannungsversorgung 22 - in der Art einer Explosionsdarstellung gezeigt.

**Figur 2b** zeigt eine Tür **24** mit Schraubanschlüssen **26a, 26b.** Die Tür 24 kann einen ersten Medienanschluss **28** zum Anschluss einer Gasversorgung und/oder einer Vakuumpumpe aufweisen.

**Figur 2c** zeigt den Niederdruckplasmakammerkörper 14 aus Glas. Der Niederdruckplasmakammerkörper 14 ist einteilig ausgebildet. Er ist vorzugsweise quaderförmig ausgebildet. Der Niederdruckplasmakammerkörper 14 erstreckt sich bevorzugt in Richtung seiner Längsachse **30.** In Richtung der Längsachse 30 gesehen, weist der Niederdruckplasmakammerkörper 14 an einer Seite eine Öffnung **32** und der Öffnung 32 gegenüberliegend eine Rückwand **34** auf. In der Rückwand 34 kann eine Rückwandöffnung **36** ausgebildet sein.

Die Öffnung 32 kann ein Kragen **38** umgeben, in dem zumindest eine Bohrung **40a, 40b, 40c, 40d,** hier mehrere Bohrungen 40a-40d, ausgebildet ist/sind. Im vorliegenden Fall ist die in Figur 2b gezeigte Tür 24 mittels der Schraubanschlüsse 26a, 26b an die Bohrungen 40a, 40b montierbar.

**Figur 2d** zeigt einen Rückwandverschluss **42,** der in die Rückwandöffnung 36 gemäß Figur 2c einsetzbar ist. Der Rückwandverschluss 42 kann einen zweiten Medienanschluss **44** und einen dritten Medienanschluss **46** aufweisen. Die Medienanschlüsse 44, 46 können zum Anschluss einer Gasversorgung und/oder einer Vakuumpumpe ausgebildet sein.

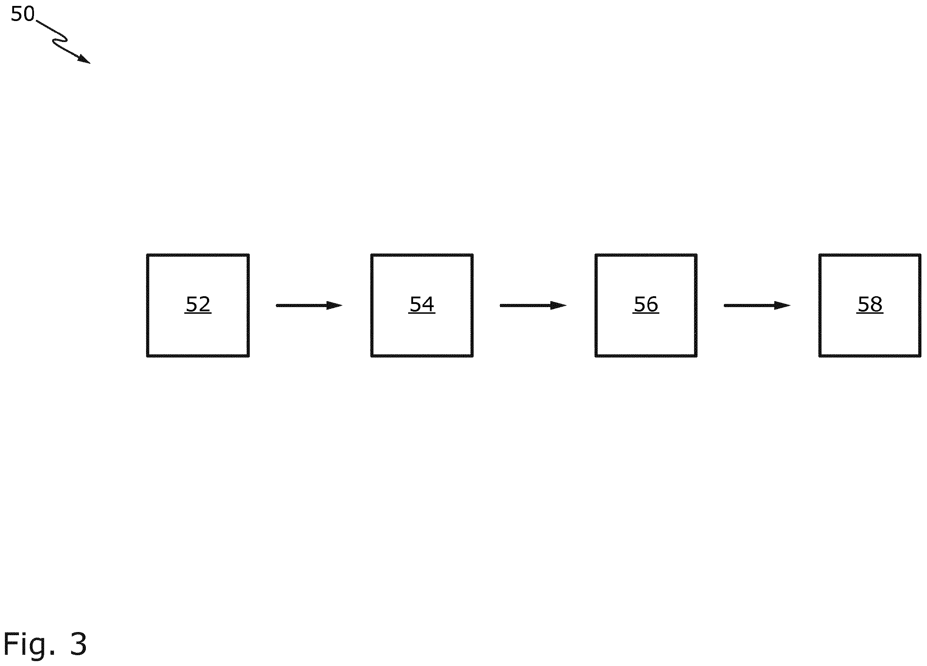

**Figur 3** zeigt ein Verfahren **50** zur Herstellung der Niederdruckplasmaanlage 10 gemäß Figur 2a.

In einem Verfahrensschritt **52** wird Glas in ein Werkzeug eingefüllt, um den Niederdruckplasmakammerkörper 14 gemäß Figur 2c herzustellen. In einem Verfahrensschritt **54** wird dann ein Pressverfahren oder ein Blas-Blas-Verfahren durchgeführt. Die Herstellung des Niederdruckplasmakammerkörpers 14 erfolgt dabei bevorzugt analog zur Massenherstellung von Glasflaschen.

In einem Verfahrensschritt **56** werden die in Figur 2b dargestellte Tür 24 und der in Figur 2d dargestellte Rückwandverschluss 42 an dem Niederdruckplasmakammerkörper 14 gemäß Figur 2d montiert. Hierdurch wird die in Figur 2a schematisch dargestellte Niederdruckplasmakammer 12 erhalten.

In einem Verfahrensschritt **58** wird/werden eine Vakuumpumpe, eine Gasversorgung und/oder eine Plasmaspannungsversorgung 22 zum Erhalt einer Niederdruckplasmaanlage 10 an die Niederdruckplasmakammer 12 angeschlossen.

Unter Vornahme einer Zusammenschau aller Figuren der Zeichnung betrifft die Erfindung zusammenfassend einen vorzugsweise quaderförmigen Niederdruckplasmakammerkörper 14 aus Glas. Die Erfindung betrifft weiterhin eine Niederdruckplasmakammer 12 mit einem solchen Niederdruckplasmakammerkörper 14. Die Niederdruckplasmakammer 12 kann an gegenüberliegenden Seiten des Niederdruckplasmakammerkörpers 14 Elektroden 16a, 16b aufweisen. Weiterhin kann die Niederdruckplasmakammer 12 an gegenüberliegenden Seiten eine Tür 24 und einen Rückwandverschluss 42 aufweisen. Tür 24 und Rückwandverschluss 42 können jeweils zumindest einen Medienanschluss 28, 44, 46 aufweisen, um einen gleichförmigen Gasfluss in der Niederdruckplasmakammer 12 zu erzielen. Die Tür 24 kann an einen sich radial von der Längsachse 30 des Niederdruckplasmakammerkörpers 14 wegerstreckenden Kragen 38 des Niederdruckplasmakammerkörpers 14 montiert sein. Der Niederdruckplasmakammerkörper 14 ist vorzugsweise im Pressverfahren oder Blas-Blas-Verfahren, analog zur industriellen Glasflaschenfertigung, hergestellt.

### Bezugszeichenliste

- 10: Niederdruckplasmaanlage
- 12: Niederdruckplasmakammer
- 14: Niederdruckplasmakammerkörper
- 16a, 16b: Elektroden
- 18: Feldlinien
- 20: Bauteil
- 22: Plasmaspannungsversorgung
- 24: Tür
- 26a, 26b: Schraubanschlüsse
- 28: erster Medienanschluss
- 30: Längsachse des Niederdruckplasmakammerkörpers
- 32: Öffnung
- 34: Rückwand
- 36: Rückwandöffnung
- 38: Kragen
- 40a, 40b, 40c, 40d: Bohrungen
- 42: Rückwandverschluss
- 44: zweiter Medienanschluss
- 46: dritter Medienanschluss
- 50: Verfahren zur Herstellung einer Niederdruckplasmaanlage 10
- 52, 54, 56, 58: Verfahrensschritte

## Patentansprüche

1. Niederdruckplasmakammer (12) für eine Niederdruckplasmaanlage (10) zur Plasmabehandlung eines Bauteils (20) in der Niederdruckplasmakammer (12),
wobei die Niederdruckplasmakammer (12) einen Niederdruckplasmakammerkörper (14) aus Glas oder Porzellan aufweist,
wobei der Niederdruckplasmakammerkörper (14) eine zumindest teilweise geschlossene Rückwand (34) aus Glas oder Porzellan aufweist,
wobei der Niederdruckplasmakammerkörper (14) eine Öffnung (32) mit einem Kragen (38) aufweist, wobei der Niederdruckplasmakammerkörper (14) einteilig ausgebildet ist,
wobei der Querschnitt des Niederdruckplasmakammerkörpers (14) viereckig
**dadurch gekennzeichnet,**
**dass** die Niederdruckplasmakammer (12) eine werkzeugfrei reversibel öffen- und schließbare Tür (24) aufweist, wobei die Tür (24) an dem Kragen

2. Niederdruckplasmakammer (12) nach Anspruch 1, bei der sich der Niederdruckplasmakammerkörper (14) länglich in Richtung seiner Längsachse (30) erstreckt.

3. Niederdruckplasmakammer (12) nach Anspruch 2, bei der der Querschnitt des Niederdruckplasmakammerkörpers (14) entlang seiner Längsachse (30) zu mehr als 40%, insbesondere zu mehr als 60%, vorzugsweise zu mehr als 80%, gleich ausgebildet ist.

4. Niederdruckplasmakammer (12) nach einem der vorhergehenden Ansprüche, bei dem die Tür (24) zumindest einem Medienanschluss (28, 44, 46), aufweist.

5. Niederdruckplasmakammer (12) nach einem der vorhergehenden Ansprüche, bei der die Tür (24) an zumindest einer Bohrung (40a-40d) im Kragen (38) befestigt ist.

6. Niederdruckplasmakammer (12) nach einem der vorhergehenden Ansprüche, bei der die Rückwand (34) des Niederdruckplasmakammerkörpers (14) einen plattenförmigen Rückwandverschluss (42) aufweist, der in eine Rückwandöffnung (36) im Niederdruckplasmakammerkörper (14) eingesetzt ist, wobei der Rückwandverschluss (42) vorzugsweise zumindest einen Medienanschluss (28, 44, 46) aufweist.

7. Niederdruckplasmakammer (12) nach einem der vorhergehenden Ansprüche, bei der der Niederdruckplasmakammerkörper (14) aus Kalk-Natron-Glas, Borosilikatglas oder Quarzglas ausgebildet ist.

8. Niederdruckplasmaanlage (10) mit einer Niederdruckplasmakammer (12) nach einem der vorhergehenden Ansprüche, wobei die Niederdruckplasmaanlage (10) eine mit der Niederdruckplasmakammer (12) verbundene Vakuumpumpe, eine mit der Niederdruckplasmakammer (12) verbundene Gasversorgung und/oder eine mit der Niederdruckplasmakammer (12) verbundene Plasmaspannungsversorgung (22) aufweist.

9. Verfahren (50) zur Herstellung einer Niederdruckplasmakammer (12) nach einem der Ansprüche 1 bis 7, wobei der Niederdruckplasmakammerkörper (14) im Pressverfahren hergestellt wird.

10. Verfahren (50) nach Anspruch 9, bei dem im Pressverfahren ein mehrteiliges Werkzeug eingesetzt wird, wobei das Werkzeug eine Form, einen Stempel und einen Deckring aufweist.

11. Verfahren (50) nach Anspruch 10, wobei die Werkzeugteile unterschiedlich temperiert werden, wobei insbesondere die Form und der Stempel gekühlt werden und der Deckring insbesondere geheizt wird.

## Claims

1. Low-pressure plasma chamber (12) for a low-pressure plasma installation (10) for plasma processing of a component (20) in the low-pressure plasma chamber (12), wherein the low-pressure plasma chamber (12) has a low-pressure plasma chamber body (14) of glass or porcelain,
wherein the low-pressure plasma chamber body (14) has an at least partially closed rear wall (34) of glass or porcelain, wherein the low-pressure plasma chamber body (14) has an opening (32) having a collar (38),
wherein the low-pressure plasma chamber body (14) is formed in one piece,
wherein the cross-section of the low-pressure plasma chamber body (14) is constructed to be rectangular,
**characterized in that** the low-pressure plasma chamber (12) has a door (24) which can be opened and closed in a reversible manner without tools, wherein the door (24) is secured to the collar.

2. Low-pressure plasma chamber (12) according to claim 1, wherein the low-pressure plasma chamber body (14) extends in an elongate manner in the direction of the longitudinal axis (30) thereof.

3. Low-pressure plasma chamber (12) according to claim 2, wherein the cross-section of the low-pressure plasma chamber body (14) is constructed along the longitudinal axis (30) thereof to be more than 40%, in particular more than 60%, preferably more than 80% identical.

4. Low-pressure plasma chamber (12) according to any one of the preceding claims, wherein the door (24) has at least one media connection (28, 44, 46).

5. Low-pressure plasma chamber (12) according to any one of the preceding claims, wherein the door (24) is secured to at least one hole (40a, 40d) in the collar (38).

6. Low-pressure plasma chamber (12) according to any one of the preceding claims, wherein the rear wall (34) of the low-pressure plasma chamber body (14) has a plate-like rear wall closure (42) which is inserted into a rear wall opening (36) in the low-pressure plasma chamber body (14), wherein the rear wall closure (42) preferably has at least one media connection (28, 44, 46).

7. Low-pressure plasma chamber (12) according to any one of the preceding claims, wherein the low-pressure plasma chamber body (14) is constructed from soda-lime glass, borosilicate glass or quartz glass.

8. Low-pressure plasma installation (10) having a low-pressure plasma chamber (12) according to any one of the preceding claims, wherein the low-pressure plasma installation (10) has a vacuum pump which is connected to the low-pressure plasma chamber (12), a gas supply which is connected to the low-pressure plasma chamber (12) and/or a plasma voltage supply (22) which is connected to the low-pressure plasma chamber (12).

9. Method (50) for producing a low-pressure plasma chamber (12) according to any one of claims 1 to 7, wherein the low-pressure plasma chamber body (14) is produced with the pressing method.

10. Method (50) according to claim 9, wherein in the pressing method a multi-component tool is used, wherein the tool has a mould, a stamp and a covering ring.

11. Method (50) according to claim 10, wherein the tool components are temperature-controlled differently, wherein in particular the mould and the stamp are cooled and the covering ring in particular is heated.

## Revendications

1. Chambre à plasma basse pression (12) pour une installation à plasma basse pression (10) pour le traitement au plasma d'un composant (20) dans la chambre à plasma basse pression (12),
la chambre à plasma basse pression (12) comprenant un corps de chambre à plasma basse pression (14) en verre ou en porcelaine,
le corps de chambre à plasma basse pression (14) comprenant une paroi arrière (34) au moins partiellement fermée en verre ou porcelaine,
le corps de chambre à plasma basse pression (14) comprenant une ouverture (32) munie d'un col (38),
le corps de chambre à plasma basse pression (14) étant configuré en une partie,
la section transversale du corps de chambre à plasma basse pression (14) étant configurée sous forme quadrangulaire,
**caractérisée en ce que**
la chambre à plasma basse pression (12) comprend une porte (24) pouvant être ouverte et fermée de manière réversible sans outil, la porte (24) étant fixée au col.

2. Chambre à plasma basse pression (12) selon la revendication 1, dans laquelle le corps de chambre à plasma basse pression (14) s'étend sous forme allongée dans la direction de son axe longitudinal (30).

3. Chambre à plasma basse pression (12) selon la revendication 2, dans laquelle la section transversale du corps de chambre à plasma basse pression (14) est configurée sous forme identique le long de son axe longitudinal (30) à hauteur de plus de 40%, notamment à hauteur de plus de 60%, de préférence à hauteur de plus de 80%.

4. Chambre à plasma basse pression (12) selon l'une quelconque des revendications précédentes, dans laquelle la porte (24) comprend au moins un raccord de fluide (28, 44, 46).

5. Chambre à plasma basse pression (12) selon l'une quelconque des revendications précédentes, dans laquelle la porte (24) est fixée à au moins un alésage (40a-40d) dans le col (38).

6. Chambre à plasma basse pression (12) selon l'une quelconque des revendications précédentes, dans laquelle la paroi arrière (34) du corps de chambre à plasma basse pression (14) comprend une fermeture de paroi arrière en forme de plaque (42), qui est insérée dans une ouverture de paroi arrière (36) dans le corps de chambre à plasma basse pression (14), la fermeture de paroi arrière (42) comprenant de préférence au moins un raccord de fluide (28, 44, 46).

7. Chambre à plasma basse pression (12) selon l'une quelconque des revendications précédentes, dans laquelle le corps de chambre à plasma basse pression (14) est configuré en verre sodocalcique, en verre borosilicaté ou en verre de quartz.

8. Installation à plasma basse pression (10) munie d'une chambre à plasma basse pression (12) selon l'une quelconque des revendications précédentes, l'installation à plasma basse pression (10) comprenant une pompe à vide reliée avec la chambre à plasma basse pression (12), une alimentation en gaz reliée avec la chambre à plasma basse pression (12) et/ou une alimentation en tension de plasma (22) reliée avec la chambre à plasma basse pression (12).

9. Procédé (50) pour la fabrication d'une chambre à plasma basse pression (12) selon l'une quelconque des revendications 1 à 7, dans lequel le corps de chambre à plasma basse pression (14) est fabriqué par un procédé de pressage.

10. Procédé (50) selon la revendication 9, dans lequel un outil à plusieurs parties est utilisé dans le procédé de pressage, l'outil comprenant un moule, un vérin et une bague de recouvrement.

11. Procédé (50) selon la revendication 10, dans lequel les parties d'outil sont différemment régulées en température, le moule et le vérin étant notamment refroidis et la bague de recouvrement étant notamment chauffée.
